(19) Europäisches Patentamt
European Patent Office
Office européen des brevets

(11) **EP 1 955 095 B1**

(12) **FASCICULE DE BREVET EUROPEEN**

(45) Date de publication et mention de la délivrance du brevet:
**19.10.2011 Bulletin 2011/42**

(21) Numéro de dépôt: **06831167.9**

(22) Date de dépôt: **24.11.2006**

(51) Int Cl.:
*G02B 3/00* *(2006.01)* *H01L 27/146* *(2006.01)*

(86) Numéro de dépôt international:
**PCT/FR2006/002581**

(87) Numéro de publication internationale:
**WO 2007/063202 (07.06.2007 Gazette 2007/23)**

(54) **IMAGEUR CMOS COMPRENANT UNE MATRICE DE MICROLENTILLES AYANT UN TAUX DE REMPLISSAGE ELEVE**

CMOS-ABBILDUNGSVORRICHTUNG MIT EINEM MIKROLINSEN-ARRAY UND MIT HOHER FÜLLRATE

CMOS IMAGING DEVICE COMPRISING A MICROLENS ARRAY EXHIBITING A HIGH FILLING RATE

(84) Etats contractants désignés:
**DE FR GB**

(30) Priorité: **30.11.2005 FR 0512137**

(43) Date de publication de la demande:
**13.08.2008 Bulletin 2008/33**

(73) Titulaires:
• **STMicroelectronics (Rousset) SAS**
**13790 Rousset (FR)**
• **UNIVERSITE PAUL CEZANNE AIX-MARSEILLE III**
**13628 Aix en Provence Cedex 1 (FR)**

(72) Inventeurs:
• **DUNNE, Bredan**
**F-13120 Gardanne (FR)**
• **FOSSATI, Caroline**
**F-84700 Sorgues (FR)**
• **GAGLIANO, Olivier**
**F-13013 Marseille (FR)**

(74) Mandataire: **Marchand, André et al**
**OMNIPAT**
**24 Place des Martyrs de la Résistance**
**13100 Aix-en-Provence (FR)**

(56) Documents cités:
WO-A-2006/060298    WO-A-2006/066081
US-A- 5 536 455    US-A1- 2003 021 967
US-A1- 2005 078 377    US-A1- 2005 110 104
US-A1- 2006 027 887    US-B1- 6 301 051
US-B1- 6 582 988

• CHOU M-C ET AL: "A novel method to fabricate gapless hexagonal micro-lens array" SENSORS AND ACTUATORS A, ELSEVIER SEQUOIA S.A., LAUSANNE, CH, vol. 118, no. 2, 28 février 2005 (2005-02-28), pages 298-306, XP004733559 ISSN: 0924-4247

## Description

La présente invention concerne les imageurs CMOS et plus particulièrement une structure de matrice de microlentilles d'imageur CMOS ainsi qu'un procédé de fabrication d'une telle matrice de microlentilles.

Les imageurs réalisés selon la technologie CMOS ("Complementary Metal Oxide Semiconductor") font actuellement l'objet d'un nombre croissant d'applications en raison de leur faible prix de revient comparativement aux imageurs CCD (Charge Coupled Device). De tels imageurs CMOS étaient initialement utilisés pour réaliser des capteurs d'image à faible résolution et de qualité médiocre (par exemple des caméras web). Aujourd'hui, après un important investissement en recherche et développement, les imageurs CMOS peuvent rivaliser avec les imageurs CCD. La présente invention s'inscrit dans cet effort de perfectionnement de cette technologie d'imageurs.

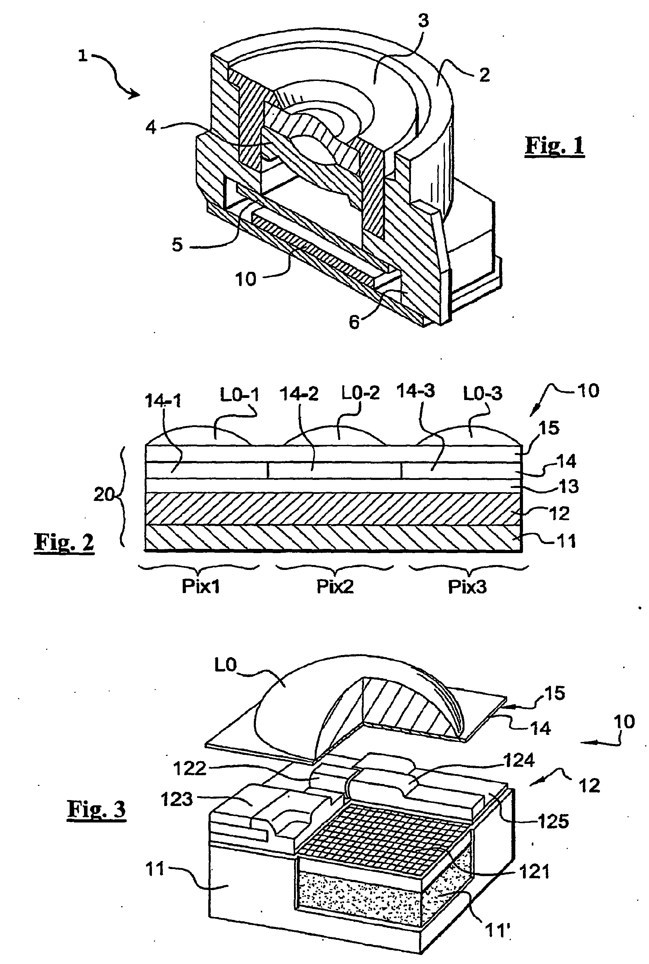

La figure 1 représente un exemple de module de capture d'images et/ou de capture vidéo utilisant un imageur CMOS, destiné par exemple à être monté dans appareil portatif tel un téléphone mobile, un appareil photographique ou une caméra vidéo. Le module 1 comprend un châssis 2, un bloc porte-lentilles 3, des lentilles 4 solidaires du bloc 3, un filtre infrarouge 5 et un support 6. Un imageur CMOS 10 est disposé sur le support 6 et reçoit la lumière passant à travers les microlentilles et le filtre infra-rouge.

L'imageur CMOS 10 se présente sous la forme d'une microplaquette de semi-conducteur et comprend une pluralité de photosites formant chacun un pixel (non visibles sur la figure 1). Chaque pixel comprend une photodiode et un circuit de contrôle et d'interconnexion de la photodiode. Les pixels sont agencés de façon matricielle et une mosaïque de filtres rouges, verts, bleus est répartie au-dessus de la matrice de pixels, généralement selon l'architecture de Bayer (les cellules d'une ligne étant alternativement rouges et vertes ou alternativement vertes et bleues). Chaque pixel est ainsi recouvert par un filtre de couleur primaire déterminée, rouge, verte ou bleue, et fournit une information de luminance relative à la couleur primaire qui lui est attribuée, formant une information de pixel.

La figure 2 est une vue en coupe schématique de l'imageur CMOS 10 dans une région correspondant à trois pixels PIX1, PIX2, PIX3. En allant du bas vers le haut, on distingue des couches 11, 12, 13, 14, 15 et des microlentilles L0 (L0-1, L0-2, L0-3). La couche 11 est le substrat semi-conducteur sur lequel l'imageur est implanté. Cette couche 11 représente ainsi la partie active de l'imageur et comprend des photodiodes et leurs circuits de contrôle et d'interconnexion associés (non détaillés). La couche 12 est formée par un matériau diélectrique qui recouvre entièrement le substrat 11. La couche 13 est une couche de passivation déposée sur l'imageur en fin de processus de fabrication CMOS. La couche 14 est formée par des résines colorées et comprend des secteurs 14-1, 14-2, 14-3 de couleur rouge, verte ou bleue formant les filtres de couleur primaire susmentionnés, à raison d'un filtre de couleur par pixel. La couche 15 est une couche de résine intermédiaire formant un support pour les microlentilles L0 et offrant une bonne planéité. Les microlentilles L0 sont agencées en une matrice dite "MLA" ("Microlens Array") à raison d'une microlentille par pixel.

La figure 3 est une vue éclatée en coupe de l'imageur 10 représentant la structure d'un pixel PIXi. Le filtre coloré 14 et la microlentille L0-i du pixel sont représentés éloignés de la partie active 12 qui est elle-même représentée sans son matériau diélectrique afin de laisser entrevoir des composants qu'elle comporte. On distingue ainsi une photodiode 121 dopée n+ formée au-dessus d'un caisson 11' dopé p implanté dans le substrat 11, et des éléments formant le circuit de contrôle et d'interconnexion de la photodiode. Ces éléments comprennent par exemple un transistor amplificateur 122, un transistor de bus de sélection de colonne 123, un transistor de remise à zéro 124, et un bus 125 de sélection de ligne.

Une particularité des imageurs CMOS, qui apparaît en figure 3, est que la photodiode n'occupe qu'une partie de la surface totale du pixel, le reste étant occupé par le circuit de contrôle et d'interconnexion de la photodiode. Pour cette raison, un pixel CMOS est généralement appelé "pixel actif", contrairement à un pixel d'imageur CCD où la photodiode occupe sensiblement toute la surface d'un pixel. En pratique, la photodiode n'occupe généralement que 50% de la surface du pixel.

La microlentille L0 permet de recueillir et de focaliser sur la photodiode 121 les photons reçus par le pixel. Sans microlentille, le rendement de l'imageur (ratio entre l'énergie lumineuse reçue et l'énergie lumineuse captée et transformée en tension électrique) serait médiocre et les images fournies présenteraient une faible luminosité et un faible contraste. Ainsi, on appelle "facteur de remplissage" ("fill factor") le pourcentage entre la surface utile du pixel (surface de la photodiode) et la surface totale de celui-ci. La prévision d'une matrice de microlentilles permet d'obtenir un facteur de remplissage plus élevé. Le facteur de remplissage correspond alors au ratio entre la surface occupée par les microlentilles et la surface totale de la partie active de l'imageur, car toute la lumière recueillie par les microlentilles est présumée envoyée sur les photodiodes.

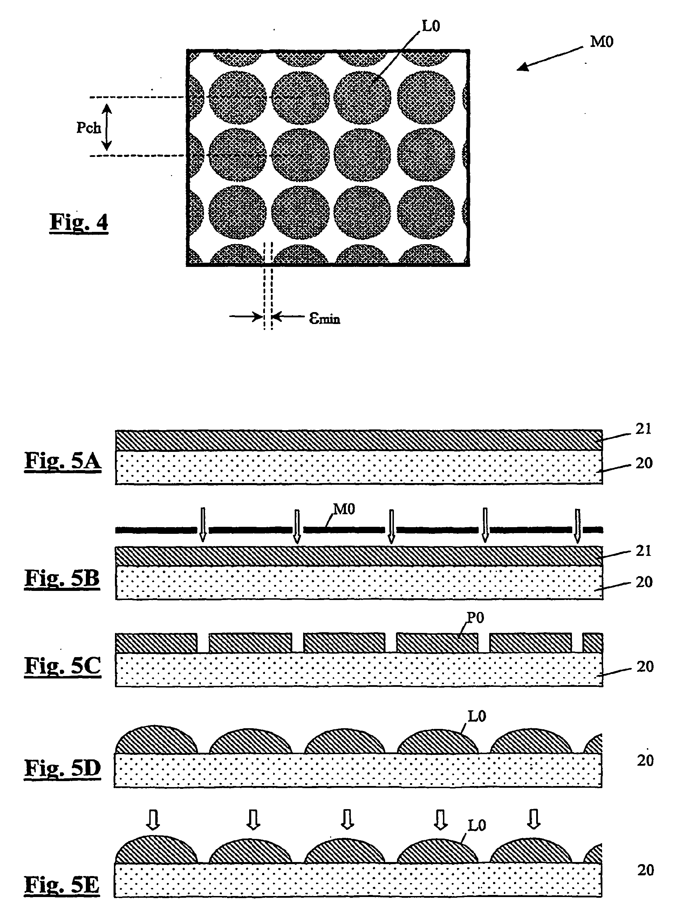

Une structure classique de matrice de microlentilles La est représentée par une vue de dessus sur la figure 4. Les microlentilles ont une base de forme circulaire et un diamètre constant, et sont espacées les unes des autres d'une distance centre à centre Pch appelée "pas" ("pitch"), correspondant au pas de la matrice de photodiodes. Les bords les plus rapprochés des microlentilles ne se touchent pas et se trouvent à une distance ε. Cette distance est généralement réduite à un minimum εmin offert par le procédé de fabrication. A titre d'exemple, avec les procédés de photolithographie actuels, la distance minimale de séparation εmin devant être respectée est de 0,4 $\mu$m. Ainsi, pour un pas de 4 $\mu$m, le diamètre maximal d'une microlentille pouvant être choisi est de 3,6 $\mu$m. Mathématiquement, en tenant compte de la forme circulaire de la base des microlentilles, le facteur de remplissage obtenu est alors de l'ordre de 64%.

Ainsi, malgré la prévision de la matrice de microlentilles, 36% de la surface de chaque pixel est perdue, soit 36% de la surface totale de l'imageur. Cet inconvénient est dû à la forme circulaire de la base des microlentilles mais également à la distance $\varepsilon_{min}$ entre les bords des microlentilles adjacentes.

Le procédé de fabrication classique d'une telle structure de microlentilles est illustré sur les figures 5A à 5E et comprend les étapes suivantes :

- dépôt d'une couche de résine polymère photosensible 21 (photorésine) sur une plaquette d'imageur 20 et cuisson douce ("soft bake") de la couche de résine (figure 5A),
- exposition de la couche de résine 21 à une lumière ultraviolette à travers un masque d'insolation M0 (figure 5B),
- retrait des parties insolées de la couche de résine 21 avec un solvant organique (figure 5C), pour obtenir une matrice de pastilles plates P0,
- fluage thermique des pastilles P0 pour obtenir des microlentilles L0 ayant une face supérieure convexe (figure 5D),
- recuit des microlentilles L0 afin d'assurer leur durcissement (figure 5E).

La résine utilisée est une résine positive, c'est-à-dire présentant une solubilité élevée en présence d'un solvant approprié (agent de gravure) après exposition aux UV. Le masque d'insolation M0 présente ainsi des zones sombres dont la forme est identique à la forme des microlentilles devant être réalisées, et des zones transparentes s'étendant entre les zones sombres, correspondant aux zones de résine devant être retirées.

Là distance minimale de séparation $\varepsilon_{min}$ entre les bords des microlentilles L0 correspond à la distance minimale entre les zones sombres du masque M0. En deçà de cette distance minimale, on observe des bavures en bordure des pastilles P0 et une mauvaise séparation de celles-ci, entraînant des distorsions dans la forme des microlentilles après l'étape de fluage.

En conclusion, la structure classique de microlentilles qui vient d'être décrite présente l'inconvénient de présenter un facteur de remplissage éloigné de la valeur idéale de 100%, en raison d'une part de la forme circulaire des microlentilles, qui limite le remplissage, et d'autre part de la distance minimale de séparation $\varepsilon_{min}$ entre les bords des microlentilles.

Les documents suivants décrivent des imageurs CMOS et/ou des matrices de microlentilles : US 2005/0 078 377, US 2005/0 110 104, US 5,536,455 et US 2003/0 215 967.

Ainsi, un objectif de la présente invention est de prévoir une structure de matrice de microlentilles qui offre un facteur de remplissage supérieur à celui offert par les matrices de microlentilles classiques.

Un autre objectif de la présente invention est de prévoir un procédé de fabrication d'une matrice de microlentilles dans lequel des microlentilles sont agencées côte à côte sans espacement entre les bords.

Pour atteindre ces objectifs, la présente invention prévoit un imageur CMOS tel que défini dans la revendication 1.

Des modes de réalisation préférentiels sont définis dans les revendications 2-6. .

L'invention concerne également un appareil portatif, notamment téléphone mobile, appareil photographique ou caméra vidéo, comprenant un imageur selon l'invention.

L'invention concerne également un procédé de fabrication d'un imageur CMOS tel que défini dans la revendication 8.

Des modes de réalisation préférentiels du procédé de fabrication sont définis dans les revendications 9-14.

Ces objets, caractéristiques et avantages ainsi que d'autres de la présente invention seront exposés plus en détail dans la description suivante d'une matrice de microlentilles selon l'invention et de divers procédés de fabrication de cette matrice de microlentilles, faite à titre non limitatif en relation avec les figures jointes parmi lesquelles :

- la figure 1 précédemment décrite représente un module de capture d'images ou de vidéo utilisant un imageur CMOS,
- la figure 2 précédemment décrite est une vue en coupe schématique de l'imageur CMOS,
- la figure 3 précédemment décrite est une vue éclatée d'un pixel de l'imageur CMOS,
- la figure 4 précédemment décrite est une vue de dessus d'une matrice de microlentilles classique pour imageur CMOS,
- les figures 5A à 5E précédemment décrites illustrent un procédé classique de fabrication de la matrice de microlentilles représentée en figure 4,
- la figure 6 est une vue de dessus d'une matrice de microlentilles selon l'invention, comprenant des microlentilles d'un premier type et d'un second type,
- la figure 7 est un graphique illustrant une étape de détermination du rayon des microlentilles du second type,
- les figures 8A à 8E sont des vues en coupe illustrant un premier procédé de fabrication de la matrice de microlentilles de la figure 6,
- la figure 9 représente un masque d'insolation utilisé par le premier procédé,
- la figure 10 est une vue de dessus d'une matrice de microlentilles réalisée selon le premier procédé,
- la figure 11 est une vue de dessus d'une microlentille du premier type et les figures 12A, 12B sont des vues en coupe de cette microlentille selon deux axes de coupe différents,

- la figure 13 illustre des propriétés optiques d'une microlentille du premier type réalisée selon le premier procédé,
- la figure 14 illustre des propriétés optiques d'une microlentille du second type réalisée selon le second procédé,
- les figures 15A à 15J sont des vues en coupe illustrant un deuxième procédé de fabrication de la matrice de microlentilles de la figure 6,
- les figures 16 et 17 représentent des masques d'insolation utilisés par le deuxième procédé,
- la figure 18 est une vue de dessus d'une matrice de microlentilles réalisée selon le deuxième procédé,
- les figures 19A à 19J sont des vues en coupe illustrant un troisième procédé de fabrication de la matrice de microlentilles de la figure 6,
- les figures 20 et 21 représentent des masques d'insolation utilisés par le troisième procédé,
- la figure 22 est un schéma équivalent d'une matrice de microlentilles réalisée selon le troisième procédé, représentée en coupe,
- la figure 23 est une vue de dessus correspondant à la vue en coupe de la figure 19F et représente des microlentilles en voie de formation,
- la figure 24 est une vue de dessus d'une matrice de microlentilles réalisée selon le troisième procédé,
- la figure 25 illustre des propriétés optiques d'une microlentille du premier type réalisée selon le troisième procédé,
- la figure 26 illustre des propriétés optiques d'une microlentille du second type réalisée selon le troisième procédé,
- les figures 27A à 27O sont des vues en coupe illustrant un quatrième procédé de fabrication de la matrice de microlentilles de la figure 6,
- les figures 28, 29, 30 représentent des masques d'insolation utilisés par le quatrième procédé,
- la figure 31 est une vue de dessus d'une matrice de microlentilles réalisée selon le quatrième procédé,
- la figure 32 illustre des propriétés optiques d'une microlentille d'un premier type réalisée selon le quatrième procédé, et
- la figure 33 illustre des propriétés optiques d'une microlentille d'un second type réalisée selon le quatrième procédé.

Structure d'une matrice de microlentilles selon l'invention

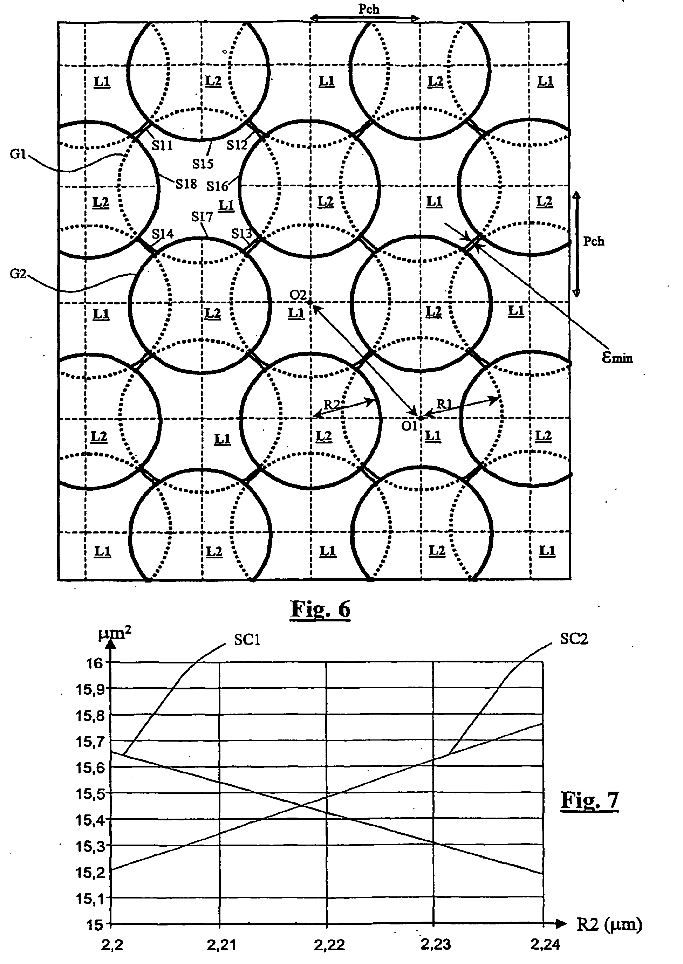

La figure 6 est une représentation abstraite d'une matrice de microlentilles selon l'invention, vue de dessus. La forme des microlentilles vues de dessus correspond à la forme de la base des microlentilles. La matrice comprend des microlentilles d'un premier type L1, ou microlentilles L1, réalisées suivant un premier gabarit G1, et des microlentilles d'un second type L2, ou microlentilles L2, réalisées suivant un second gabarit G2. Les gabarits sont représentés en traits pointillés tandis que les bases des microlentilles sont représentées en traits continus.

La matrice de microlentilles présente les caractéristiques générales suivantes :

- les gabarits G1 et G2 sont des cercles de rayons R1 et R2 et sont agencés en alternance selon des lignes et des colonnes de la matrice, repérées par des traits pointillés horizontaux et verticaux formant un maillage,
- la distance entre le centre d'une microlentille L1 et le centre d'une microlentille adjacente L2 est égale au pas Pch de la matrice de photosites (pixels) de l'imageur CMOS correspondant, qui est donc également le pas de la matrice de microlentilles,
- la somme des rayons R1 et R2 est supérieure au pas Pch, de sorte que les gabarits G1 et G2 présentent des zones de recouvrement, comme cela apparaît sur la figure,
- la base des microlentilles L2 a une forme correspondant au gabarit G2 (les traits pointillés du gabarit G2 étant ainsi recouverts par les traits continus représentant les microlentilles L2),
- la base des microlentilles L1 a une forme qui délimite une aire correspondant à l'aire couverte par le gabarit G1 à laquelle on soustrait les zones de recouvrement avec le gabarit G2 des microlentilles L2 adjacentes (quatre zones de recouvrement pour chaque microlentille L1).

Il en résulte que la base des microlentilles L1 a une forme "octogonale à bords arrondis" présentant quatre bords à courbure positive S11, S12, S13, S14 correspondant à des secteurs angulaires du gabarit G1 et quatre bords à courbure négative S15, S16, S17, S18 correspondant à des secteurs angulaires des gabarits G2 des microlentilles. L2 adjacentes.

Détermination des gabarits G1, G2

Les surfaces actives (surfaces réelles) des microlentilles L1 et L2 sont choisies identiques, afin que les photosites couverts par les microlentilles L1 reçoivent la même quantité de lumière que les photosites couverts par les microlentilles L2 (à éclairement identique) Ainsi, les rayons R1, R2 des gabarits sont de préférence déterminés de manière que les surfaces actives des microlentilles L1, L2 soient égales. A cet effet, on calcule d'abord le rayon R1 puis on détermine le rayon R2 en fonction de R1.

Calcul de R1

On désigne par [O1 O2] la distance entre les centres O1 est O2 de deux microlentilles L1 adjacentes, soit deux microlentilles de même type appartenant à deux lignes adjacentes et à deux colonnes adjacentes. La distance [O1 O2] est égale à la diagonale du maillage de la matrice, soit :

$$[\text{O1 O2}] = \sqrt{[\text{Pch}^2 + \text{Pch}^2]} \quad (1)$$

Par ailleurs, le rayon R1 du gabarit G1 obéit à la relation :

$$2R1 + \varepsilon = [\text{O1 O2}] \quad (2)$$

ε étant la distance entre les bords de deux microlentilles L1 adjacentes.

En combinant (1) et (2) on en déduit que :

$$R1 = 1/2(\sqrt{2}*\text{Pch} - \varepsilon) \quad (3)$$

En réduisant la distance ε à la valeur minimale εmin imposée par le procédé de fabrication (tolérance du procédé), afin d'obtenir le facteur de remplissage le plus élevé, il vient que le rayon R1 est égal à :

$$R1 = 1/2(\sqrt{2}*\text{Pch} - \varepsilon\text{min}) \quad (4)$$

Ainsi, par exemple, si le pas Pch est égal à 4 μm et εmin égal à 0,4 μm, le rayon R1 est égal à 2,63 μm.

Calcul de R2

Le rayon R1 étant connu pour des valeurs de Pch et de εmin connues, l'équation d'égalité des surfaces des microlentilles de type L1 et de type L2 peut être résolue au moyen du graphique illlustré en figure 7. L'axe des abscisses du graphique est gradué en μm et l'axe des ordonnées est gradué en μm² (micromètres carrés). On trace une courbe SC2 qui représente la valeur de la surface des microlentilles L2 lorsque R2 augmente, puis une courbe SC1 représentant, la surface des microlentilles L1 en fonction de R2 (pour R1 constant). Cette surface décroît lorsque R2 croit car elle est égale à l'aire du gabarit G1 moins l'aire des zones de recouvrement, qui croit lorsque R2 croit. Ainsi, les deux courbes présentent un point d'intersection qui correspond au point d'égalité des surfaces des microlentilles L1 et L2. L'abscisse du point d'intersection est la valeur de R2 recherchée. Par exemple, on voit ici que le rayon R2 doit être égal à 2,22 μm environ quand R1 = 2,63 μm pour que les surfaces des microlentilles L1, L2 soient égales. En pratique, le rayon R2 peut aussi être déterminé au moyen d'un logiciel de simulation optique comprenant des algorithmes de calcul de surfaces de microlentilles, par exemple un simulateur ZEMAX.

Une telle structure de matrice de microlentilles présente l'avantage d'offrir un facteur de remplissage élevé (surface utile de la matrice de microlentilles relativement à la surface totale de la matrice). Les microlentilles L1 peuvent être monofocales (petit point lumineux sur la photodiode correspondante) ou multifocales (tache lumineuse sur la photodiode), tandis que les microlentilles L2 sont de préférence monofocales.

La distance focale des microlentilles L1 doit être de préférence sensiblement égale à celle des microlentilles L2 et cette distance focale conmune doit correspondre à la distance entre la matrice de microlentilles et la matrice de photodiodes (épaisseur des couches 12, 13, 14 et 15 en figure 2). La distance focale étant fonction du rayon des microlentilles et de leur hauteur, les microlentilles L1 du premier type et les microlentilles L2 du second type ne présentent pas, en principe, la même hauteur si leurs distances focales respectives sont égales. Par exemple, des microlentilles monofocales L1 de rayon R1 = 2,63 μm et des microlentilles monofocales L2 de rayon R2 = 2,22 μm doivent présenter des hauteurs respectives H1 = 930nm et H2 = 672nm pour l'obtention d'une distance focale identique de l'ordre de 8 μm. Toutefois, un compromis peut être fait et un exemple de réalisation de microlentilles L1, L2 ayant des hauteurs identiques sera décrit plus loin.

Enfin, si les microlentilles L1 sont réalisées multifocales, la hauteur des microlentilles L1 est déterminée de manière que la distance focale moyenne de la lentille (moyenne entre la plus petite distance focale et la plus grande distance focale) soit de préférence égale à la distance entre la matrice de microlentilles et la matrice de photodiodes, pour éviter que la tache lumineuse déborde au-delà des régions de photodiodes.

Fabrication de la matrice de microlentilles

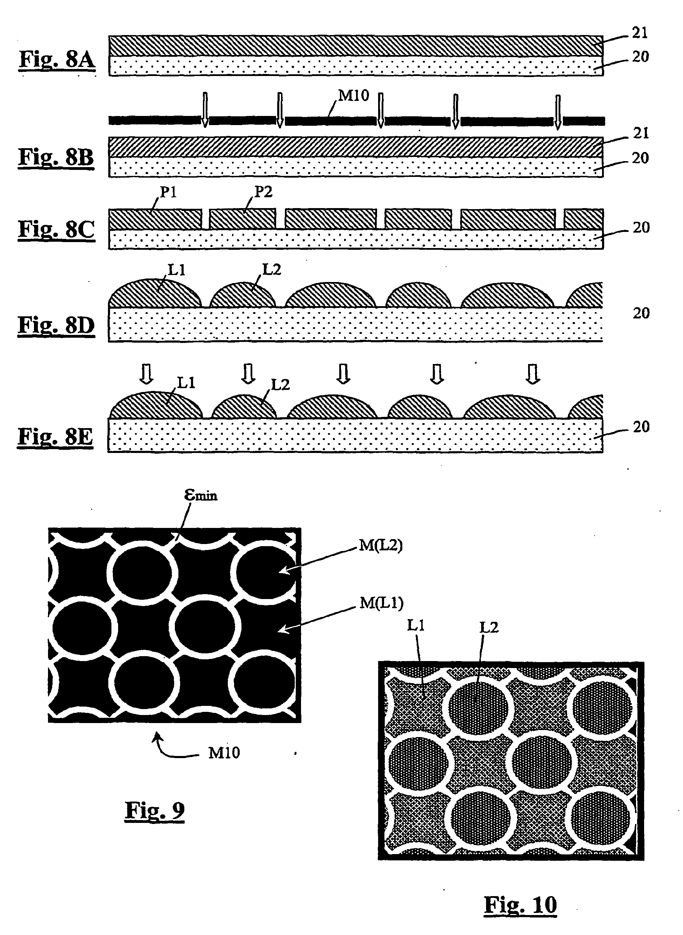

On décrira dans ce qui suit quatre procédés de fabrication d'une matrice de microlentilles, désignés "procédé 1", "procédé 2", "procédé 3" et "procédé 4" dont seulement les procédés 2, 3 et 4 sont des procédés selon l'invention telle que définie dans la revendication 8 et illustrés respectivement par les groupes de figures 8A-8E, 15A-15J, 19A-19J et 27A-27O.

Dans ces divers procédés, la matrice de microlentilles est réalisée sur une plaquette d'imageur qui est représentée schématiquement par une couche 20. Cette couche 20 comprend les couches 11 à 15 représentées en figure 2, la couche 11 (substrat et composants) formant la partie active de l'imageur.

Bien que les figures susmentionnées illustrent seulement la formation de quelques microlentilles de la matrice, les procédés 1 à 4 permettent de réaliser collectivement une pluralité d'imageurs sur une tranche de silicium ("wafer"), qui est ensuite découpée pour obtenir des microplaquettes d'imageur individuelles.

Chacun de ces procédés comprend des étapes de dépôt et de cuisson douce d'une couche ou de deux couches de résine, d'insolation de la couche de résine ou des couches de résine à travers un masque d'insolation (résine positive), de retrait des parties insolées de la résine, de fluage de la résine restant présente sur la plaquette d'imageur et de durcissement de la résine. Ces étapes sont mises en oeuvre de façon classique en ce qui concerne les paramètres du processus. Ainsi, les étapes de dépôt des couches de résine sont réalisées en déposant une quantité de résine positive au centre de la plaquette d'imageur 20 et en étalant la résine sur la plaquette par centrifugation. Les étapes de cuisson douce sont conduites pendant quelques dizaines de secondes à une température de l'ordre de 100°C. Les étapes d'insolation sont mises en oeuvre avec une lumière ultraviolette pendant un temps correspondant au transfert d'une énergie photonique de l'ordre de 300 mJ. Les étapes de retrait de la résine insolée comprennent une étape consistant à tremper la couche de résine dans un bain de solvant organique à température déterminée (par exemple 23°) pendant une durée de l'ordre de quelques dizaines de secondes (par exemple 80s). Les étapes de fluage sont réalisées en exposant la résine à une température de l'ordre de 200°C à 240°C pendant quelques dizaines de secondes (par exemple 30 à 60s). Enfin, les étapes de durcissement sont des étapes de recuit des microlentilles, pendant quelques minutes et à une température de l'ordre de 200°C.

Procédé 1, figures 8A à 8E

Ce procédé utilise un seul masque d'insolation M10, représenté en figure 9 (vue partielle) comprenant des zones sombres M(L1) de forme octogonale à bords arrondis et des zones sombres M(L2) circulaires pour graver une couche de résine 21 et réaliser simultanément des microlentilles de type L1 et de type L2. La distance minimale entre les zones sombres du masque M10, par exemple 0,4$\mu$m, est imposée par le procédé et définit la distance minimale $\epsilon$min entre deux microlentilles (distance bord à bord).

Le procédé 1 comprend plus particulièrement les étapes suivantes :

- dépôt de la couche de résine 21 sur la plaquette d'imageur 20 est cuisson douce de la couche de résine (figure 8A),
- exposition de la couche de résine à une lumière UV à travers le masque M10 (figure 8B),
- retrait des parties insolées de la couche de résine 21, pour obtenir des pastilles de résine d'un premier type P1 et d'un second type P2 (figure 8C),
- fluage thermique des pastilles P1 et P2 pour obtenir des microlentilles du premier type L1 et du second type L2 (figure 8D),
- durcissement des microlentilles L1, L2 (figure 8E).

La figure 10 est une vue de dessus de la matrice de microlentilles obtenue (vue partielle). La base des microlentilles de type L1 a une forme octogonale à bords arrondis telle que définie plus haut, tandis que la base des microlentilles L2 présente la forme circulaire également définie plus haut (Cf. calcul de R1 et R2). Ces formes octogonale et circulaire sont conférées ici aux pastilles P1 et P2 au moment de la gravure de la couche de résine (figure 8C), et définissent la forme de la base des microlentille après que la face supérieure des pastilles a "gonflé" sous l'effet du fluage pour former la face supérieure convexe des microlentilles. Les parties sombres du masque M10 ont donc une forme identique à celle des pastilles P1, P2 du fait de l'utilisation d'une résine positive.

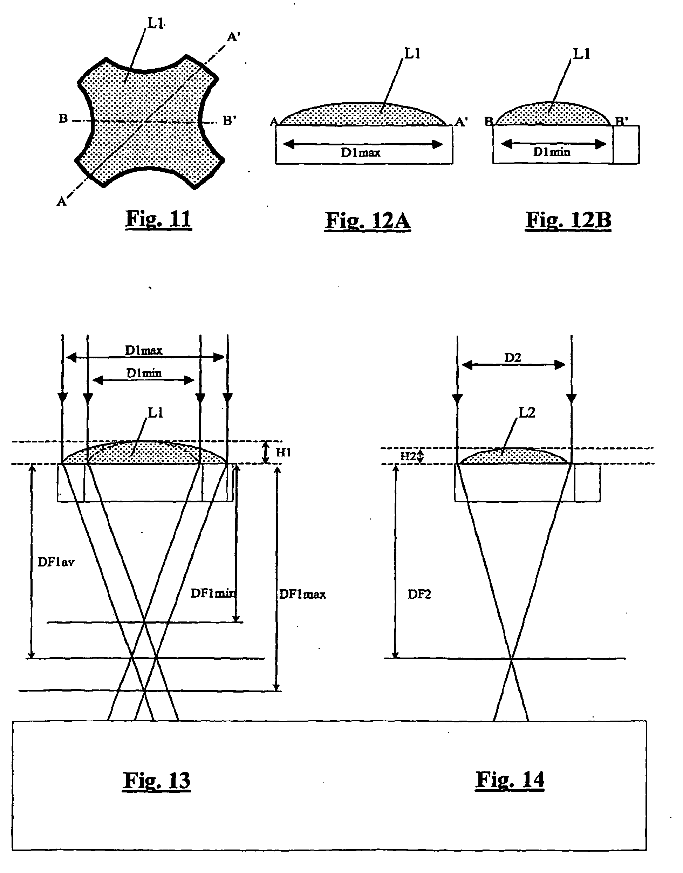

Les pastilles P1 ayant une forme octogonale à bords arrondis et les pastilles P2 ayant une forme circulaire, les microlentilles L1 obtenues après fluage des pastilles P1 sont multifocales tandis que les microlentilles L2 sont monofocales. Ceci sera mieux compris en se référant aux figures 11 à 14.

La figure 11 représente une microlentille de type L1 vue de dessus, la figure 12A représente la microlentille L1 en coupe suivant un axe AA' représenté en figure 11 et la figure 12B représente la microlentille L1 suivant un axe BB' également représenté en figure 11. L'axe AA' est un axe de plus grand diamètre de la microlentille L1, le long duquel la microlentille présente un diamètre D1max. L'axe BB' est un axe de plus petit diamètre de la microlentille L1, le long duquel elle présente un diamètre D1min. Ainsi, comme représenté en figure 13, la microlentille L1 est l'équivalent d'une pluralité de microlentilles de diamètres différents ayant chacune une distance focale déterminée comprise entre une distance focale minimale DF1min correspondant au plus petit diamètre Dlmin et une distance focale maximale DF1max correspondant au plus grand diamètre D1max. La microlentille L1 présente une distance focale moyenne DFlav (moyenne des distances focales) qui doit de préférence correspondre à la distance entre la matrice de microlentilles et la matrice de photodiodes de l'imageur, pour que la tache lumineuse fournie par les microlentille ne déborde pas au-delà des régions de photodiodes. Inversement, comme représenté en figure 14, une microlentille L2 ne présente qu'une seule distance focale DF2 qui doit également, de préférence, correspondre à la distance entre le plan de la matrice de microlentilles et le plan des photodiodes de l'imageur.

Pour que la distance focale moyenne DFlav des microlentilles L1 soit égale à la distance focale DF2 des microlentilles L2, les microlentilles L1 doivent présenter une hauteur H1 déterminée et les microlentilles L2 une hauteur H2 différente de H1. Ces hauteurs sont fonction de l'épaisseur de la couche de résine avant gravure, soit la hauteur des pastilles de résine avant fluage. La relation entre la hauteur des pastilles et l'épaisseur des microlentilles est donnée par des abaques fournis par le fabricant de résine ou établies par des expérimentations. Toutefois, les microlentilles L1 et L2 étant réalisées ici à partir de la même couche de résine, un compromis devra être fait. Par exemple, l'épaisseur de la couche de résine est choisie de manière que l'écart entre la hauteur réelle des microlentilles L1 et la valeur théorique H1 soit approximativement égal à l'écart entre la hauteur réelle des microlentilles L2 et la valeur théorique H2.

En raison de la distance εmin devant être respectée entre les bords des microlentilles adjacentes de même type ou de type différent, le facteur de remplissage obtenu en mettant en oeuvre le procédé 1 est de l'ordre de 80%.

Procédés 2 à 4

Les procédés 2 à 4 qui seront maintenant décrits offrent avantageusement les caractéristiques suivantes :

- utilisation de deux couches de résine pour un contrôle différencié des hauteurs des microlentilles de type L1 et des microlentilles de type L2,
- suppression de la distance εmin entre les bords des microlentilles adjacentes de type L1 et de type L2 et obtention d'un facteur de remplissage de l'ordre de 96%,
- obtention de microlentilles de type L1 monofocales (procédé 3 et 4 seulement).

Bien que l'obtention de microlentilles L1 monofocales soit présenté ici comme un avantage, la réalisation de microlentilles L1 multifocales (procédé 1 et procédé 2) ne constitue pas un inconvénient rédhibitoire pour la mise en oeuvre de l'invention, l'essentiel étant que les taches lumineuses obtenues avec des microlentilles multifocales ne débordent pas au-delà des régions de photodiodes. Ainsi, en pratique, le choix du meilleur procédé dépendra des caractéristiques et des performances des équipements de photolithographie utilisés, et du prix de revient des microlentilles. Un compromis pourra être fait entre la précision du procédé (dispersion des caractéristiques des microlentilles), le type de microlentilles obtenu (multifocales ou monofocales) et le prix de revient des microlentilles, en tenant compte également des applications visées (imageurs de qualité ou imageurs "bas de gamme").

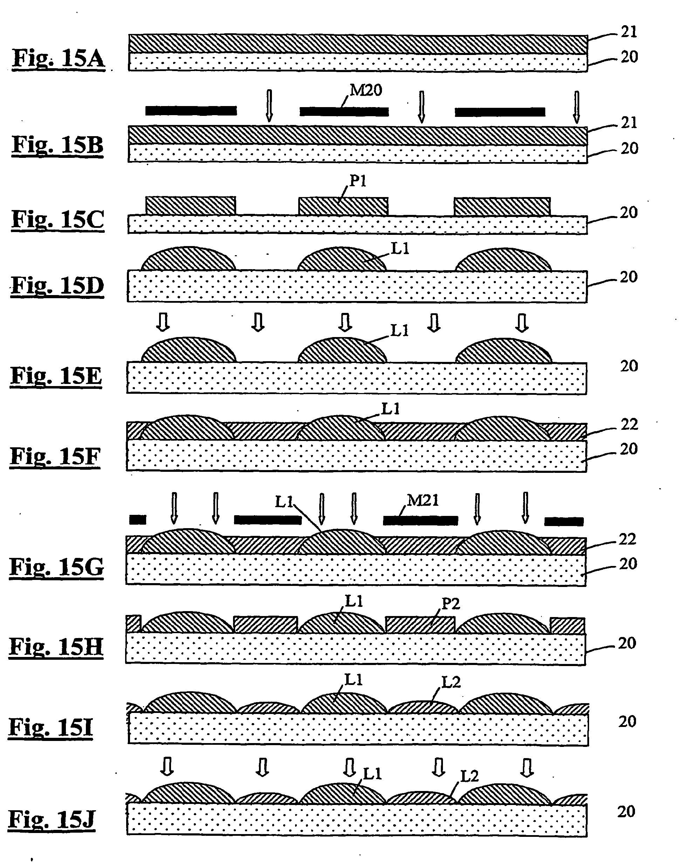

Procédé 2, figures 15A à 15J

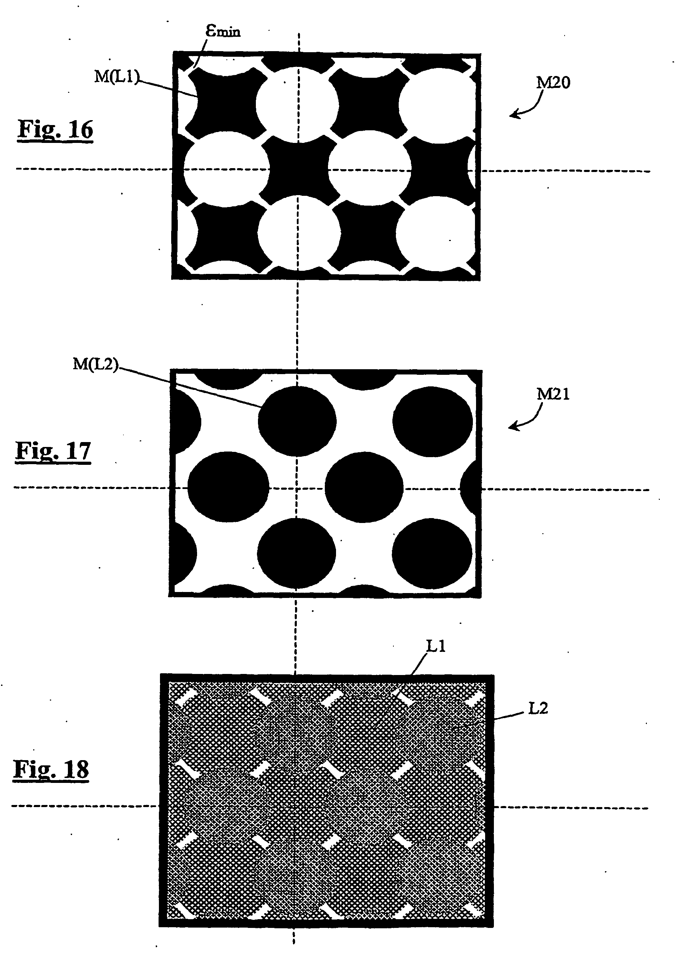

Ce procédé se distingue du procédé 1 en ce que les microlentilles L1 et les microlentilles L2 sont réalisées au moyen de deux couches de résine 21, 22, et deux masques d'insolation M20 et M21 représentés sur les figures 16 et 17 (vue partielle). Le masque M20 comporte des zones sombres M(L1) de forme octogonale à bords arrondis qui permettent de réaliser en premier lieu des microlentilles de type L1. Le masque M21 comporte des zones sombres M(L2) de forme circulaire qui permettent de réaliser ensuite les microlentilles de type L2.
Plus particulièrement, le procédé 2 comprend les étapes suivantes :

- dépôt de la couche de résine 21 sur une plaquette d'imageur 20 et cuisson douce de la couche de résine 21,
- insolation de la couche de résine 21 à travers le masque M20,
- retrait des parties insolées de la couche de résine 21 pour obtenir des pastilles de résine d'un premier type P1 (figure 15C),
- fluage thermique des pastilles pour obtenir des microlentilles du premier type L1 (figure 15D),
- durcissement des microlentilles L1 par recuit (figure 15E),
- dépôt de la couche de résine 22 sur la plaquette d'imageur 20 et cuisson douce de la couche de résine 22 (figure 15F),
- insolation de la couche de résine 22 à travers le masque M21 (figure 15G),
- retrait des parties insolées de la couche de résine 22, pour obtenir des pastilles de résine d'un second type P2 (figure 15H),
- fluage thermique des pastilles P2 pour obtenir les microlentilles du second type L2 (figure 15I),
- durcissement des microlentilles L2 (figure 15J).

Le dépôt de la couche de résine 22 est effectué comme le dépôt de la couche 21, par centrifugation, la résine s'étendant par capillarité et sous l'effet de la force centrifuge dans les régions dépourvues de résine et s'étendant entre les microlentilles L1. Les microlentilles L1 ne sont pas attaquées par le solvant organique pendant la gravure de la couche de résine 22, car le processus de recuit rend la résine résistante à l'agent de gravure.

Les hauteurs respectives des microlentilles L1 et L2 sont donc ajustées ici de façon différenciée, grâce à un contrôle correspondant de l'épaisseur des couches de résine 21 et 22. On contrôle ainsi avec une plus grande précision les distances focales des microlentilles L1 et L2, de manière que celles-ci soient égales ou proches.

Les microlentilles de type L1 sont comme précédemment multifocales, puisque les pastilles P1 présentent, avant fluage, un contour octogonal à bords arrondis conféré par le masque M20. Les microlentilles de type L2 sont comme précédemment monofocales puisque les pastilles P2 présentent, avant fluage, un contour circulaire conféré par le masque M21.

On notera également l'avantage annoncé plus haut : si la distance minimale εmin entre les bords des microlentilles adjacentes de type L1 ne peut être supprimée (Cf. masque M20 fig. 16), par contre la distance entre les bords des microlentilles adjacentes de type L1 et de type L2 peut être supprimée grâce au procédé de gravure à deux couches de résine et l'utilisation de deux masques d'isolation. Pour cela, il suffit de conférer un diamètre approprié aux zones sombres M(L2) du masque M21. On obtient ainsi la matrice de microlentilles représentée sur la figure 18, dans laquelle les bords des microlentilles L1 sont accolés aux bords des microlentilles L2, le facteur de remplissage étant de l'ordre de 96%.

Enfin, les couches de résine 21, 22 sont de préférence réalisées avec la même résine, et présentent donc les mêmes propriétés optiques. Toutefois, dans une variante pouvant être explorée par l'homme de l'art, des résines ayant des indices optiques différents pourraient être utilisées afin de bénéficier d'un degré de liberté supplémentaire dans le choix des hauteurs des microlentilles.

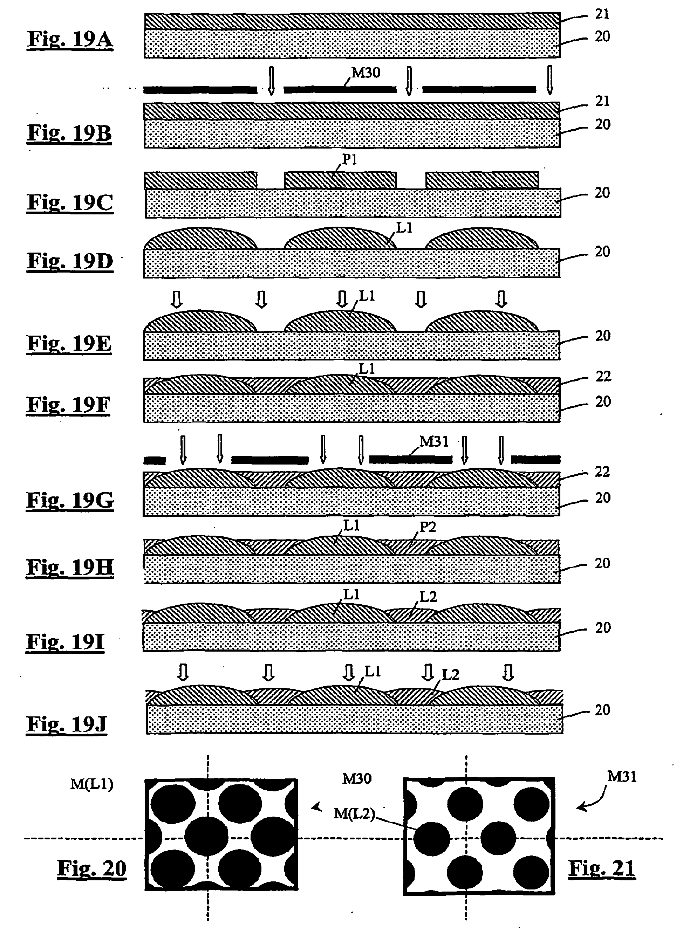

Procédé 3, figures 19A à 19J

Ce procédé comprend, comme le procédé 2, le dépôt de deux couches de résine 21, 22. Ces couches sont impérativement réalisées ici avec des résines identiques, ayant les mêmes propriétés optiques (indice), pour des raisons qui apparaîtront plus loin.

Le procédé 3 se distingue du procédé 2 en ce que les pastilles P1 permettant de réaliser les microlentilles L1 ne sont pas gravées avant fluage pour obtenir la forme octogonale à bords arrondis. Ces pastilles sont réalisées avec un masque d'insolation M30, représenté en figure 20 (vue partielle), qui comporte des zones sombres M(L1) ayant un contour circulaire. Ainsi, après fluage des pastilles P1, on obtient des microlentilles L1 monofocales. Par ailleurs, les microlentilles de type L2 sont réalisées avec un masque d'insolation M31 représenté en figure 21 (vue partielle) qui est identique au masque M21 du procédé 2 (fig. 17), et ont également un contour circulaire. Pour obtenir la forme octogonale à bords arrondis qui caractérise les microlentilles L1 vues de dessus, les microlentilles L2 sont formées avec chevauchement sur les microlentilles L1.

Plus particulièrement, le procédé 3 comprend les étapes suivantes:

- dépôt de la couche de résine 21 sur une plaquette d'imageur 20 et cuisson douce de la couche de résine 21 (figure 19A),
- insolation de la couche de résine 21 à travers le masque M30 (figure 19B),
- retrait des parties insolées de la couche de résine 21 pour obtenir des pastilles de résine de type P1 ayant ici une base circulaire (figure 19C),
- fluage thermique des pastilles P1 pour obtenir des microlentilles du premier type L1 monofocales (figure 19D),
- durcissement des microlentilles L1 par recuit (figure 19E),
- dépôt d'une couche de résine 22 sur la plaquette d'imageur et cuisson douce de la couche de résine 22 (figure 19F),
- insolation de la couche de résine 22 à travers le masque M31 (figure 19G),
- retrait des parties insolées de la couche de résine 22, pour obtenir des pastilles de résine de type P2 qui recouvrent ici les bords des microlentilles L1 (figure 19H),
- fluage thermique des pastilles P2 pour obtenir les microlentilles du second type L2 (figure 19I),
- durcissement des microlentilles L2 par recuit (figure 19J),

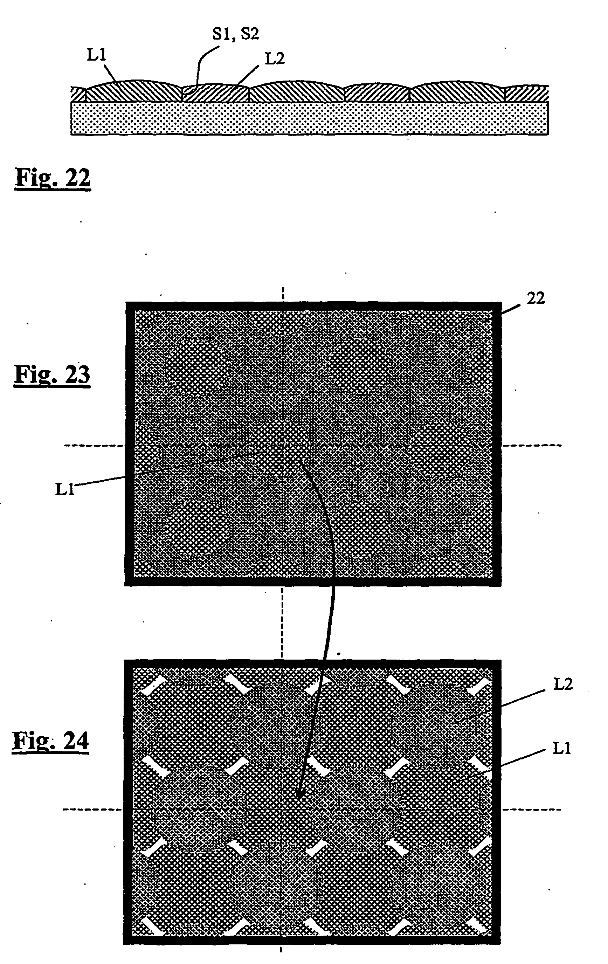

La figure 23 est une vue de dessus de la matrice de microlentilles en cours de formation, après dépôt de la couche de résine 22 et avant gravure de celle-ci (étape illustrée par la figure 19F). Les microlentilles L1 sont partiellement recouvertes par la couche de résine 22 et seul les sommets des microlentilles émergent de la couche 22. Après gravure de la couche de résine 22, et fluage des pastilles P2, on obtient la matrice de microlentilles représentée en figure 24 qui, vue de dessus, est identique à la matrice obtenue avec le procédé 2 (fig. 18).

La vue en coupe de la figure 22 est un schéma équivalent (au plan optique) de la matrice de microlentilles représentée sur les figures 19I ou 19J, suivant un axe de coupe correspondant au plus petit diamètre des microlentilles L1 (soit un axe passant par les zones de chevauchement). Ce schéma équivalent montre que le chevauchement des microlentilles L1 par les microlentilles L2 ne modifie pas les propriétés optiques des microlentilles, si celles-ci sont réalisées avec la même résine. Plus précisément, ce schéma équivalent représente des microlentilles L1 et L2 agencées côte à côte sans espacement et ayant des bords verticaux S1, S2 parallèles. En d'autres termes, la résine des microlentilles L1 qui est recouverte par la résine des microlentilles L2 fait partie des microlentilles L2 et non des microlentilles L1, d'un point de vue optique. Bien entendu, les bords verticaux représentés en figure 22 ne concernent que les zones de chevauchement : la face supérieure convexe des microlentilles L1, L2 a un profil en arc de cercle qui s'étend jusqu'à la base des microlentilles dans les régions sans chevauchement.

L'homme de l'art notera qu'en raison des régions de chevauchement, la surface active des microlentilles L2 est sensiblement diminuée par rapport à la surface active théorique correspondant au gabarit G2. Inversement, la surface active des microlentilles L1 est sensiblement augmentée par rapport à la surface active théorique correspondant à la surface du gabarit G1 moins la surface des zones de recouvrement avec le gabarit G2. Ainsi, les gabarits G1, G2 sont corrigés par rapport au modèle théorique au moment de leur conception, de manière à prendre en compte les variations de surface active dues aux régions de chevauchement.

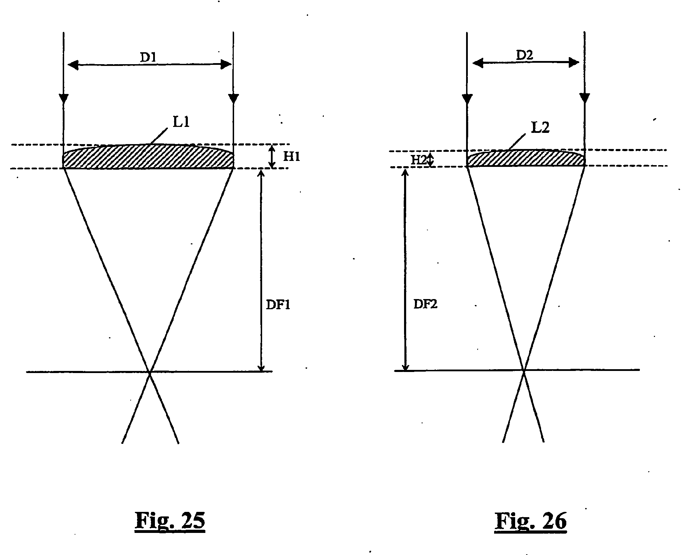

Les figures 25 et 26 représentent respectivement les microlentilles L1 et L2 en coupe selon l'axe de coupe de plus petit diamètre des microlentilles L1 et L2, ainsi que les distances focales respectives DF1 et DF2 de ces microlentilles, qui sont fonction de leurs hauteurs H1 et H2. Les microlentilles L1 sont ici monofocales et leur distance focale DF1 est de préférence égale, sinon proche, de la distance focale DF2 des microlentilles L2.

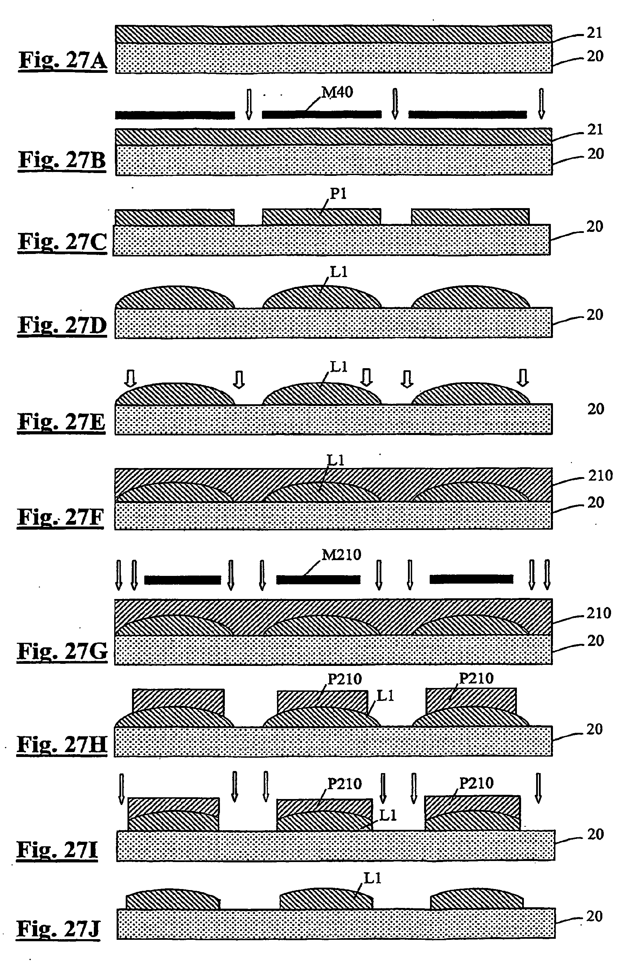

## Procédé 4, figures 27A à 27O

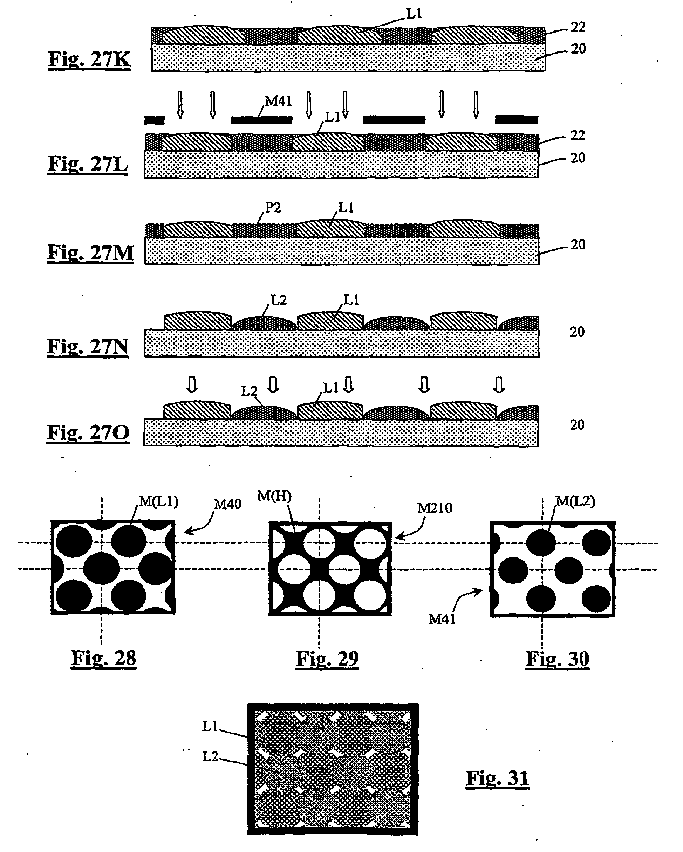

Le procédé 4 se distingue du procédé 3 en ce que trois couches de résine 21, 210, 22 sont utilisées, ainsi que trois masques d'insolation M40, M210, M41 représentés sur les figures 28, 29, 30. La couche de résine 210 est une couche temporaire gravée au moyen du masque M210 pour former un masque de gravure P210 qui est supprimé après avoir été utilisé. Ce masque de gravure permet de graver les microlentilles L1 au moyen d'un plasma gazeux, pour conférer à la base des microlentilles L1 la forme octogonale à bords arrondis. Le masque M210 comporte ainsi, comme on le voit sur la figure 29, des zones sombres M(H) de forme octogonale à bords arrondis.

Le masque M40 est utilisé pour graver la couche de résine 21 et est identique au masque M30 du procédé 3. On obtient ainsi des pastilles P1 ayant un contour circulaire et les microlentilles L1 obtenues sont monofocales, bien qu'étant ensuite gravées au plasma pour présenter une base octogonale à bords arrondis. De même, le masque M41 est utilisé pour graver la couche de résine. 22 et réaliser les microlentilles L2, et est identique au masque M31 du procédé 3.

Le procédé 4 comprend plus particulièrement les étapes suivantes:

- dépôt de la couche de résine 21 sur une plaquette d'imageur 20 et cuisson douce de la couche de résine 21 (figure 27A),
- insolation de la couche de résine 21 à travers le masque d'insolation M40 (figure 27B),
- retrait des parties insolées de la couche de résine 21 pour obtenir les pastilles de résine P1 à contour circulaire (figure 27C),
- fluage thermique des pastilles P1 pour obtenir des microlentilles L1 monofocales présentant une base circulaire (figure 27D),
- durcissement des microlentilles L1 par recuit (figure 27E),
- dépôt de la couche de résine de masquage 210 sur la plaquette d'imageur et cuisson douce de la couche de résine (figure 27F),
- insolation de la couche de résine 210 à travers le masque d'insolation M210 (figure 27G),
- retrait des parties insolées de la couche 210, pour l'obtention du masque de gravure en résine P210 qui est l'image du masque d'insolation M210 et comprend des régions de forme octogonale à bords arrondis qui couvrent les microlentilles L1 (figure 27H, et forme du masque d'insolation M210 en figure 29);
- gravure au plasma des microlentilles L1 à travers le masque de gravure en résine P210, de manière que les microlentilles L1 présentent une base octogonale à côtés arrondis (figure 27I),
- retrait au moyen d'un solvant organique des résidus du masque de gravure en résine (figure 27J) (une partie de l'épaisseur du masque de gravure ayant été détruite pendant la gravure au plasma),
- dépôt de la couche de résine 22 sur la plaquette d'imageur et cuisson douce de la couche de résine 22 (figure 27K),
- insolation de la couche de résine 22 à travers le masque d'insolation M41 (figure 27L),
- retrait des parties insolées de la couche 22, pour obtenir des pastilles de résine P2 (figure 27M),
- fluage thermique des pastilles P2 pour obtenir les microlentilles L2 (figure 27N), et
- durcissement des microlentilles par recuit (figure 27O).

Il apparaît sur les figures 27J à 27O que la gravure au plasma confère aux microlentilles L1 des flancs droits verticaux dans les zones de recouvrement des gabarits G1, G2. La matrice de microlentilles vue de dessus est identique à la matrice obtenue avec les procédés 2 et 3, comme représenté sur la figure 31.

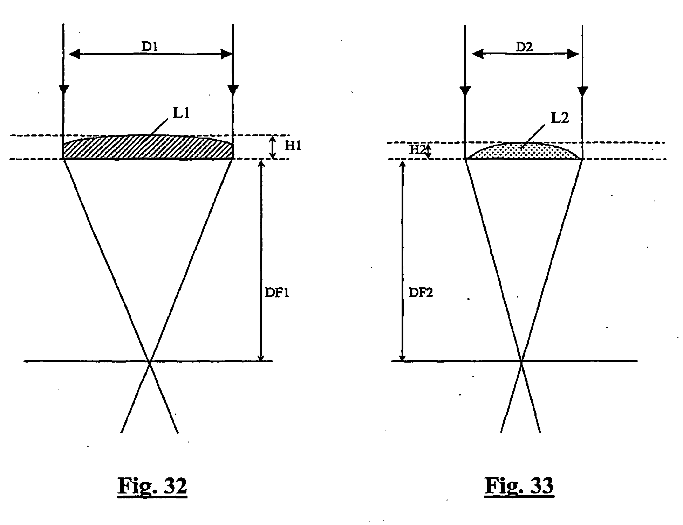

Les figures 32 et 33 représentent respectivement les microlentilles L1 et L2 en coupe selon l'axe de coupe de plus petit diamètre des microlentilles L1 et représentent également les distances focales DF1 et DF2 des microlentilles L1 et L2, qui sont fonction de leurs hauteurs H1 et H2. Comme avec le procédé 2, les microlentilles L1 ne présentent qu'un plan focal et leur distance focale DF1 est de préférence égale, sinon proche, de la distance focale DF2 des microlentilles L2.

## Revendications

1. Imageur CMOS comprenant une matrice de photosites et une matrice de microlentilles comprenant des microlentilles d'un premier type (L1) réalisées suivant un premier gabarit circulaire (G1) présentant un premier rayon (R1) et des microlentilles d'un second type (L2) réalisées suivant un second gabarit circulaire (G2) présentant un second rayon (R2) inférieur au premier rayon, les microlentilles du premier et du second type étant réparties en alternance selon un pas constant (Pch), les microlentilles du second type (L2) présentant une base circulaire (G2) correspondant au second gabarit (G2), **caractérisé en ce que** :

    - les premier (G1) et second (G2) gabarits présentent des zones de recouvrement,
    - les rayons (R1, R2) des premier (G1) et second (G2) gabarits, sont définis de manière que la surface du premier gabarit (G1) moins la surface des zones de recouvrement non recouverte par le second gabarit (G2) soit égale à la surface du second gabarit (G2), et

- chaque microlentille du premier type (L1) est entourée de quatre microlentilles adjacentes du second type (L2) et présente une base de forme octogonale à bords arrondis présentant quatre bords arrondis à courbure positive (S11, S12, S 13, S14) passant par un même cercle (G1) correspondant au premier gabarit circulaire (G1), et quatre bords arrondis à courbure négative (S 15, S 16, S 17, S 18) correspondant chacun au bord circulaire d'une microlentille adjacente du second type (L2).

2. Imageur selon la revendication 1, dans lequel les microlentilles du second type (L2) recouvrent les microlentilles du premier type (L1) dans les zones où la base des microlentilles du premier type présente des bords arrondis à courbure négative.

3. Imageur selon la revendication 1, dans lequel les microlentilles du premier type (L1) sont multifocales, leur face supérieure présentant plusieurs courbures, et les microlentilles du second type (L2) sont monofocales.

4. Imageur selon la revendication 1, dans lequel les microlentilles du premier type (L1) et du second type (L2) sont monofocales.

5. Imageur selon la revendication 1, dans lequel les microlentilles du second type (L2) ne recouvrent pas les microlentilles du premier type (L1) et les bords les plus rapprochés des microlentilles du premier type (L1) et des microlentilles du second type (L2) présentent une distance de séparation égale à une distance de séparation ($\varepsilon$min) entre les bords les plus rapprochés de deux microlentilles du premier type (L1).

6. Imageur selon la revendication 1, dans lequel les microlentilles du second type (L2) ne recouvrent pas les microlentilles du premier type (L1) et les bords les plus rapprochés des microlentilles du premier type (L1) et des microlentilles du second type (L2) présentent une distance de séparation nulle ou inférieure à une distance de séparation ($\varepsilon$min) entre les bords les plus rapprochés de deux microlentilles du premier type (L1).

7. Appareil portatif, notamment téléphone mobile, appareil photographique ou caméra vidéo, comprenant un imageur selon les revendications 1 à 6.

8. Procédé de fabrication d'un imageur CMOS comprenant une matrice de photosites, comprenant une étape de fabrication d'une matrice de microlentilles sur une face de l'imageur, **caractérisé en ce qu'**il comprend :

- une étape de conception de l'architecture de la matrice de microlentilles, comprenant la prévision d'un premier gabarit circulaire (G1) présentant un premier rayon (R1) correspondant à des microlentilles d'un premier type (L1) et d'un second gabarit circulaire (G2) présentant un second rayon (R2) inférieur au premier rayon (R1) et correspondant à des microlentilles d'un second type (L2), dans laquelle :

  - les premier et second gabarits sont définis de manière que les microlentilles du premier type (L1) soient réparties en alternance avec les microlentilles du second type (L2) selon un pas constant (Pch),
  - les premier et second gabarits sont définis de manière à présenter des zones de recouvrement, la somme des rayons (R1, R2) des premier (G1) et second (G2) gabarits étant supérieure au pas (Pch) de la matrice, et
  - les rayons (R1, R2) des premier (G1) et second (G2) gabarits sont définis de manière que la surface du premier gabarit (G1) non recouverte par le second gabarit (G2) soit égale à la surface du second gabarit,

- une étape de fabrication de microlentilles du premier type (L1) comprenant une étape de dépôt d'une première couche de résine (21), une étape d'insolation de la première couche de résine par l'intermédiaire d'un premier masque d'insolation (M10, M20, M30, M40), et une étape de gravure de la première couche de résine, et
- une étape de fabrication de microlentilles du second type (L2) comprenant une étape de dépôt d'une seconde couche de résine (21, 22), une étape d'insolation de la seconde couche de résine par l'intermédiaire d'un second masque d'insolation (M10, M21, M31, M41), et une étape de gravure de la seconde couche de résine,

et dans lequel :

- les étapes d'insolation et de gravure sont conduites de manière que les microlentilles du second type (L2) présentent une base circulaire qui est sensiblement délimitée par le second gabarit circulaire (G2), et que les microlentilles du premier type (L1) présentent une base octogonale à bords arrondis dont la forme correspond sensiblement à l'aire du premier gabarit circulaire à laquelle sont soustraites les zones de recouvrement, la base octogonale présentant quatre côtés arrondis à courbure positive (S11, S 12, S 13, S 14) passant par un même cercle correspondant au premier gabarit circulaire (G1), et quatre bords arrondis à courbure négative (S 15, S 16, S 17, S 18) correspondant chacun au bord circulaire d'une microlentille adjacente du second type (L2).

9. Procédé selon la revendication 8, dans lequel:

   - l'étape de fabrication de microlentilles du premier type (L1) comprend une étape de fabrication de pastilles de résine (P1) ayant un contour octogonal à bords arrondis (S11, S12, S 13, S 14, S 15, S16, S 17, S 18), et une étape de fluage des pastilles pour obtenir les micro lentilles du premier type (L1), et
   - l'étape de fabrication de microlentilles du second type (L2) comprend une étape de fabrication de pastilles de résine (P2) ayant un contour circulaire et une étape de fluage des pastilles pour obtenir les microlentilles du second type (L2).

10. Procédé selon la revendication 8, dans lequel :

   - l'étape de fabrication de microlentilles du premier type (L1) comprend une étape de fabrication de pastilles de résine (P1) ayant un contour circulaire, une étape de fluage des pastilles pour obtenir des microlentilles du premier type (L1) ayant un contour circulaire, et une étape de gravure des microlentilles du premier type de manière que les microlentilles du premier type présentent une base octogonale à bords arrondis, et
   - l'étape de fabrication de microlentilles du second type (L2) comprend une étape de fabrication de pastilles de résine (P2) ayant un contour circulaire et une étape de fluage des pastilles pour obtenir les microlentilles du second type (L2).

11. Procédé selon la revendication 8, dans lequel

   - l'étape de fabrication de microlentilles du premier type (L1) comprend une étape de fabrication de pastilles de résine (P1) ayant un contour circulaire, une étape de fluage des pastilles pour obtenir des microlentilles du premier type (L1) ayant un contour circulaire, et
   - l'étape de fabrication de microlentilles du second type (L2) comprend une étape de fabrication de pastilles de résine (P2) ayant un contour circulaire et recouvrant les microlentilles du premier type dans les zones de recouvrement des gabarits (G1, G2), et une étape de fluage des pastilles pour obtenir les microlentilles du second type (L2).

12. Procédé selon la revendication 8, dans lequel:

   - l'étape de fabrication de microlentilles du premier type (L1) comprend une étape de fabrication de pastilles de résine (P1) ayant un contour octogonal à bords arrondis (S11, S12, S 13, S 14, S 15, S16, S 17, S18), et une étape de fluage des pastilles pour obtenir les microlentilles du premier type (L1), et
   - l'étape de fabrication de microlentilles du second type (L2) comprend une étape de fabrication de pastilles de résine (P2) ayant un contour circulaire et une étape de fluage des pastilles pour obtenir les microlentilles du second type (L2),

   les pastilles de résine (P1) ayant un contour octogonal à bords arrondis et les pastilles de résine (P2) ayant un contour circulaire étant fabriquées simultanément par insolation d'une même couche de résine (21) au moyen d'un même masque d'insolation (M10) et gravure simultanée des pastilles.

13. Procédé selon la revendication 10, dans lequel l'étape de gravure des microlentilles du premier type (P1) est conduite au moyen d'un plasma gazeux.

14. Procédé selon la revendication 13, dans lequel l'étape de gravure des microlentilles du premier type (P1) est conduite par l'intermédiaire d'un masque de gravure (P210) formé par dépôt d'une couche de résine de masquage (210) sur la plaquette d'imageur, insolation de la couche de résine de masquage à travers un masque d'insolation (M210), retrait de la résine de masquage insolée, pour l'obtention du masque de gravure (P210).

**Claims**

1. A CMOS imaging device comprising an array of photosites and a microlens array which comprises microlenses of a first type (L1) produced according to a first circular template (G1) having a first radius (R1) and microlenses of a second type (L2) produced according to a second circular template (G2) having a second radius (R2) smaller than the first radius, the microlenses of the first type and of the second type being spread alternately according to a constant pitch (Pch), the microlenses of the second type (L2) having a circular base (G2) corresponding to the second template (G2), **characterized in that**:

   - the first (G1) and second (G2) templates have overlapping areas,
   - the radii (R1, R2) of the first (G1) and second (G2) templates are defined so that the surface of the first template (G1) minus the surface of the overlapping areas not overlapped by the second template (G2) is equal to the surface of the second template (G2), and

- each microlens of the first type (L1) is surrounded by four adjacent microlenses of the second type (L2) and has an octagonal base with rounded edges having four rounded edges with positive curvature (S11, S12, S 13, S 14) passing through a same circle (G1) corresponding to the first circular template (G1), and four rounded edges with negative curvature (S 15, S16, S 17, S 18) each corresponding to the circular edge of an adjacent microlens of the second type (L2).

2. Imaging device according to claim 1, wherein the microlenses of the second type (L2) overlap the microlenses of the first type (L1) in the areas in which the base of the microlenses of the first type has rounded edges with negative curvature.

3. Imaging device according to claim 1, wherein the microlenses of the first type (L1) are multifocal, their upper face having several curvatures, and the microlenses of the second type (L2) are monofocal.

4. Imaging device according to claim 1, wherein the microlenses of the first type (L1) and of the second type (L2) are monofocal.

5. Imaging device according to claim 1, wherein the microlenses of the second type (L2) do not overlap the microlenses of the first type (L1) and the closest edges of the microlenses of the first type (L1) and of the microlenses of the second type (L2) have a separation distance equal to a separation distance (εmin) between the closest edges of two microlenses of the first type (L1).

6. Imaging device according to claim 1, wherein the microlenses of the second type (L2) do not overlap the microlenses of the first type (L1) and the closest edges of the microlenses of the first type (L1) and of the microlenses of the second type (L2) have a separation distance equal to zero or smaller than a separation distance (εmin) between the closest edges of two microlenses of the first type (L1).

7. A portable device, particularly a mobile telephone, camera or video camera, comprising an imaging device according to claims 1 to 6.

8. A method for manufacturing a CMOS imaging device comprising an array of photosites, comprising a step of manufacturing a microlens array on a face of the imaging device, **characterized in that** it comprises:

    - a step of designing the architecture of the microlens array, comprising providing a first circular template (G1) having a first radius (R1) corresponding to microlenses of a first type (L1) and a second circular template (G2) having a second radius (R2) smaller than the first radius (R1) and corresponding to microlenses of a second type (L2), wherein:

    - the first and second templates are defined so that the microlenses of the first type (L1) are spread alternately with the microlenses of the second type (L2) according to a constant pitch (Pch),
    - the first and second templates are defined so as to have overlapping areas, the sum of the radii (R1, R2) of the first (G1) and second (G2) templates being greater than the pitch (Pch) of the array, and
    - the radii (R1, R2) of the first (G1) and second (G2) templates are defined so that the surface of the first template (G1) not overlapped by the second template (G2) is equal to the surface of the second template,

    - a step of manufacturing microlenses of the first type (L1) comprising a step of depositing a first layer of resin (21), a step of exposing the first layer of resin through a first exposure mask (M10, M20, M30, M40), and a step of etching the first layer of resin, and
    - a step of manufacturing microlenses of the second type (L2) comprising a step of depositing a second layer of resin (21, 22), a step of exposing the second layer of resin through a second exposure mask (M10, M21, M31, M41), and a step of etching the second layer of resin,

and wherein:

    - the exposing and etching steps are conducted so that the microlenses of the second type (L2) have a circular base which is substantially delimited by the second circular template (G2), and so that the microlenses of the first type (L1) have an octagonal base with rounded edges the shape of which corresponds substantially to the area of the first circular template from which the overlapping areas are subtracted, the octagonal base having four rounded sides with positive curvature (S11, S12, S13, S14) passing through a same circle corresponding to the first circular template (G1), and four rounded edges with negative curvature (S15, S16, S17, S18) each corresponding to the circular edge of an adjacent microlens of the second type (L2).

9. Method according to claim 8, wherein:

    - the step of manufacturing microlenses of the first type (L1) comprises a step of manufacturing resin pellets (P1) having an octagonal contour with rounded edges (S11, S12, S13, S14, S15, S16, S17, S18), and a step of creeping the pellets to obtain the microlenses of the first type (L1), and

- the step of manufacturing microlenses of the second type (L2) comprises a step of manufacturing resin pellets (P2) having a circular contour and a step of creeping the pellets to obtain the microlenses of the second type (L2).

10. Method according to claim 8, wherein:

- the step of manufacturing microlenses of the first type (L1) comprises a step of manufacturing resin pellets (P1) having a circular contour, a step of creeping the pellets to obtain microlenses of the first type (L1) having a circular contour, and a step of etching the microlenses of the first type so that the microlenses of the first type have an octagonal base with rounded edges, and

- the step of manufacturing microlenses of the second type (L2) comprises a step of manufacturing resin pellets (P2) having a circular contour and a step of creeping the pellets to obtain the microlenses of the second type (L2).

11. Method according to claim 8, wherein:

- the step of manufacturing microlenses of the first type (L1) comprises a step of manufacturing resin pellets (P1) having a circular contour, a step of creeping the pellets to obtain microlenses of the first type (L1) having a circular contour, and

- the step of manufacturing microlenses of the second type (L2) comprises a step of manufacturing resin pellets (P2) having a circular contour and overlapping the microlenses of the first type in the overlapping areas of the templates (G1, G2), and a step of creeping the pellets to obtain the microlenses of the second type (L2).

12. Method according to claim 8, wherein:

- the step of manufacturing microlenses of the first type (L1) comprises a step of manufacturing resin pellets (P1) having an octagonal contour with rounded edges (S11, S 12, S 13, S 14, S 15, S 16, S 17, S 18), and a step of creeping the pellets to obtain the microlenses of the first type (L1), and

- the step of manufacturing microlenses of the second type (L2) comprises a step of manufacturing resin pellets (P2) having a circular contour and a step of creeping the pellets to obtain the microlenses of the second type (L2),

the resin pellets (P1) having an octagonal contour with rounded edges and the resin pellets (P2) having a circular contour being manufactured simultaneously by exposing a same layer of resin (21) by means of a same exposure mask (M10) and by simultaneously etching the pellets.

13. Method according to claim 10, wherein the step of etching the microlenses of the first type (P1) is conducted by means of a gaseous plasma.

14. Method according to claim 13, wherein the step of etching the microlenses of the first type (P1) is conducted by means of an etching mask (P210) formed by depositing a layer of masking resin (210) on the imaging device plate, exposing the layer of masking resin through an exposure mask (M210), and removing the exposed masking resin, to obtain the etching mask (P210).

**Patentansprüche**

1. CMOS-Abbildungsvorrichtung mit einem Fotostellen-Array und einem Mikrolinsen-Array mit Mikrolinsen eines ersten Typs (L1), die entsprechend einer ersten kreisförmigen Schablone (G1) mit einem ersten Radius (R1) gestaltet sind, und mit Mikrolinsen eines zweiten Typs (L2), die entsprechend einer zweiten kreisförmigen Schablone (G2) mit einem zweiten Radius (R2) gestaltet sind, welcher kleiner ist als der erste Radius, wobei die Mikrolinsen des ersten und des zweiten Typs wechselweise entsprechend einer konstanten Schrittweite (Pch) angeordnet sind, wobei die Mikrolinsen des zweiten Typs (L2) eine kreisförmige Basis (G2) aufweisen, welche der zweiten Schablone (G2) entspricht, **dadurch gekennzeichnet, dass**:

- die erste Schablone (G1) und die zweite Schablone (G2) Überdeckungszonen aufweisen,

- die Radien (R1, R2) der ersten Schablone (G1) und der zweiten Schablone (G2) derart definiert sind, dass die Fläche der ersten Schablone (G1) abzüglich der Fläche der Überdeckungszonen, welche nicht von der zweiten Schablone (G2) überdeckt ist, dieselbe Größe aufweist, wie die Fläche der zweiten Schablone (G2), und

- jede Mikrolinse des ersten Typs (L1) von vier benachbarten Mikrolinsen des zweiten Typs (L2) umgeben ist und eine achteckige Basis mit abgerundeten Kanten aufweist, welche vier abgerundete Kanten mit einer positiven Krümmung (S11, S 12, S13, S14) aufweist, die durch denselben, der ersten kreisförmigen Schablone (G1) entsprechenden Kreis (G1) hindurchgehen, und vier abgerundete Kanten mit einer negativen Krümmung (S 15, S 16, S 17, S 18) aufweist, die jeweils der kreisförmigen Kante einer benachbarten Mikrolinse des zweiten Typs (L2) entsprechen.

2. Abbildungsvorrichtung nach Anspruch 1, bei der die Mikrolinsen des zweiten Typs (L2) die Mikrolinsen des ersten Typs (L1) in jenen Zonen überdecken, in denen die Basis der Mikrolinsen des ersten Typs abgerundete Kanten mit negativer Krümmung aufweist.

3. Abbildungsvorrichtung nach Anspruch 1, bei der die Mikrolinsen des ersten Typs (L1) multifokal sind, wobei ihre Oberseiten mehrere Krümmungen aufweisen, und die Mikrolinsen des zweiten Typs (L2) monofokal sind.

4. Abbildungsvorrichtung nach Anspruch 1, bei der die Mikrolinsen des ersten Typs (L1) und die Mikrolinsen des zweiten Typs (L2) monofokal sind.

5. Abbildungsvorrichtung nach Anspruch 1, bei der die Mikrolinsen des zweiten Typs (L2) die Mikrolinsen des ersten Typs (L1) nicht überdecken und die einander am nächsten liegenden Kanten der Mikrolinsen des ersten Typs (L1) und der Mikrolinsen des zweiten Typs (L2) einen Trennungsabstand aufweisen, der einem Trennungsabstand (εmin) zwischen den einander am nächsten liegenden Kanten von zwei Mikrolinsen des ersten Typs (L1) entspricht.

6. Abbildungsvorrichtung nach Anspruch 1, bei der die Mikrolinsen des zweiten Typs (L2) die Mikrolinsen des ersten Typs (L1) nicht überdecken und die einander am nächsten liegenden Kanten der Mikrolinsen des ersten Typs (L1) und der Mikrolinsen des zweiten Typs (L2) einen Trennungsabstand gleich Null oder kleiner als ein Trennungsabstand (εmin) zwischen den einander am nächsten liegenden Kanten von zwei Mikrolinsen des ersten Typs (L1) aufweisen.

7. Tragbares Gerät, insbesondere Mobiltelefon, Fotoapparat oder Videokamera mit einer Abbildungsvorrichtung nach den Ansprüchen 1 bis 6.

8. Verfahren zur Herstellung einer CMOS-Abbildungsvorrichtung mit einem Fotostellen-Array, welches einen Schritt zur Herstellung eines Mikrolinsen-Arrays auf einer Seite der Abbildungsvorrichtung umfasst, **dadurch gekennzeichnet, dass** es folgende Schritte umfasst:

- einen Schritt zur Entwicklung der Architektur des Mikrolinsen-Arrays, welcher das Vorsehen einer ersten kreisförmigen Schablone (G1) mit einem ersten Radius (R1) entsprechend Mikrolinsen eines ersten Typs (L1) und einer zweiten kreisförmigen Schablone (G2) mit einem zweiten Radius (R2) umfasst, welcher kleiner als der erste Radius (R1) ist und Mikrolinsen eines zweiten Typs (L2) entspricht, bei dem:

- die erste und die zweite Schablone derart definiert sind, dass die Mikrolinsen des ersten Typs (L1) wechselweise mit den Mikrolinsen des zweiten Typs (L2) entsprechend einer konstanten Schrittweite (Pch) angeordnet sind,
- die erste und die zweite Schablone derart definiert sind, dass sie Überdeckungszonen aufweisen, wobei die Summe der Radien (R1, R2) der ersten Schablone (G1) und der zweiten Schablone (G2) größer ist als die Schrittweite (Pch) des Arrays, und
- die Radien (R1, R2) der ersten Schablone (G1) und der zweiten Schablone (G2) derart definiert sind, dass die nicht von der zweiten Schablone (G2) überdeckte Fläche der ersten Schablone (G1) dieselbe Größe aufweist wie die Fläche der zweiten Schablone,

- einen Schritt zur Herstellung von Mikrolinsen des ersten Typs (L1) mit einem Schritt zur Aufbringung einer ersten Harzschicht (21), einem Schritt zur Belichtung der ersten Harzschicht durch eine erste Belichtungsmaske (M10, M20, M30, M40), und einem Schritt zur Ätzung der ersten Harzschicht, und
- einen Schritt zur Herstellung von Mikrolinsen des zweiten Typs (L2) mit einem Schritt zur Aufbringung einer zweiten Harzschicht (21, 22), einem Schritt zur Belichtung der zweiten Harzschicht mittels einer zweiten Belichtungsmaske (M10, M21, M31, M41), und einem Schritt zur Ätzung der zweiten Harzschicht,

und bei dem:

- die Belichtungs- und Ätzungsschritte derart durchgeführt werden, dass die Mikrolinsen des zweiten Typs (L2) eine kreisförmige Basis aufweisen, welche im Wesentlichen von der zweiten kreisförmigen Schablone (G2) begrenzt ist, und dass die Mikrolinsen des ersten Typs (L1) eine achteckige Basis mit abgerundeten Kanten aufweisen, deren Form im Wesentlichen der Fläche der ersten kreisförmigen Schablone abzüglich der Überdeckungszonen entspricht, wobei die achteckige Basis vier abgerundete Seiten mit positiver Krümmung (S11, S 12, S 13, S 14) aufweist, die durch denselben, der ersten kreisförmigen Schablone (G1) entsprechenden Kreis hindurchgehen, und vier abgerundete Kanten mit negativer Krümmung (S 15, S 16, S 17, S 18), die jeweils der kreisförmigen Kante einer benachbarten Mikrolinse des zweiten Typs (L2) entsprechen.

9. Verfahren nach Anspruch 8, bei dem:

- der Schritt zur Herstellung von Mikrolinsen des ersten Typs (L1) einen Schritt zur Herstellung von Harzplättchen (P1) mit einem achteckigen Umriss mit abgerundeten Kanten (S11, S 12, S13, S 14, S 15, S 16, S 17, S 18) und einen Schritt des Kriechens der Plättchen zur Erzeugung der Mikrolinsen des ersten Typs (L1) umfasst, und
- der Schritt zur Herstellung von Mikrolinsen des zweiten Typs (L2) einen Schritt zur Herstellung von Harzplättchen (P2) mit einem kreisförmigen Umriss und einen Schritt des Kriechens der Plättchen zur Erzeugung der Mikrolinsen des zweiten Typs (L2) umfasst.

10. Verfahren nach Anspruch 8, bei dem:

- der Schritt zur Herstellung von Mikrolinsen des ersten Typs (L1) einen Schritt zur Herstellung von Harzplättchen (P1) mit einem kreisförmigen Umriss, einen Schritt des Kriechens der Plättchen zur Erzeugung von Mikrolinsen des ersten Typs (L1) mit einem kreisförmigen Umriss, und einen Schritt zur Ätzung der Mikrolinsen des ersten Typs umfasst, so dass die Mikrolinsen des ersten Typs eine achteckige Basis mit abgerundeten Kanten aufweisen, und
- der Schritt zur Herstellung von Mikrolinsen des zweiten Typs (L2) einen Schritt zur Herstellung von Harzplättchen (P2) mit einem kreisförmigen Umriss und einen Schritt des Kriechens der Plättchen zur Erzeugung der Mikrolinsen des zweiten Typs (L2) umfasst.

11. Verfahren nach Anspruch 8, bei dem:

- der Schritt zur Herstellung von Mikrolinsen des ersten Typs (L1) einen Schritt zur Herstellung von Harzplättchen (P1) mit einem kreisförmigen Umriss, einen Schritt des Kriechens der Plättchen zur Erzeugung von Mikrolinsen des ersten Typs (L1) mit einem kreisförmigen Umriss umfasst, und
- der Schritt zur Herstellung von Mikrolinsen des zweiten Typs (L2) einen Schritt zur Herstellung von Harzplättchen (P2), welche einen kreisförmigen Umriss aufweisen und die Mikrolinsen des ersten Typs in den Überdeckungszonen der Schablonen (G1, G2) überdecken, und einen Schritt des Kriechens der Plättchen zur Erzeugung der Mikrolinsen des zweiten Typs (L2) umfasst.

12. Verfahren nach Anspruch 8, bei dem:

- der Schritt zur Herstellung von Mikrolinsen des ersten Typs (L1) einen Schritt zur Herstellung von Harzplättchen (P1) mit einem achteckigen Umriss mit abgerundeten Kanten (S11, S 12, S 13, S 14, S 15, S 16, S 17, S 18) und einen Schritt des Kriechens der Plättchen zur Erzeugung der Mikrolinsen des ersten Typs (L1) umfasst, und
- der Schritt zur Herstellung von Mikrolinsen des zweiten Typs (L2) einen Schritt zur Herstellung von Harzplättchen (P2) mit einem kreisförmigen Umriss und einen Schritt des Kriechens der Plättchen zur Erzeugung der Mikrolinsen des zweiten Typs (L2) umfasst,

wobei die einen achteckigen Umriss mit abgerundeten Kanten aufweisenden Harzplättchen (P1) und die einen kreisförmigen Umriss aufweisenden Harzplättchen (P2) gleichzeitig durch Belichtung einer selben Harzschicht (21) mittels einer selben Belichtungsmaske (M10) und simultaner Ätzung der Plättchen hergestellt werden.

13. Verfahren nach Anspruch 10, bei dem der Schritt zur Ätzung der Mikrolinsen des ersten Typs (P1) mittels eines Gasplasmas durchgeführt wird.

14. Verfahren nach Anspruch 13, bei dem der Schritt zur Ätzung der Mikrolinsen des ersten Typs (P1) mittels einer Ätzmaske (P210) durchgeführt wird, welche durch Aufbringung einer Maskierungs-Harzschicht (210) auf der Platine der Abbildungsvorrichtung, Belichtung der Maskierungs-Harzschicht durch eine Belichtungsmaske (M210), Entfernung des belichteten Maskierungs-Harzes zur Erzeugung der Ätzmaske (P210) gebildet wird.

**Fig. 1**

**Fig. 2**

**Fig. 3**

**Fig. 4**

Pch

L0

M0

$\varepsilon_{min}$

**Fig. 5A**

21

20

M0

**Fig. 5B**

21

20

P0

**Fig. 5C**

20

L0

**Fig. 5D**

20

L0

**Fig. 5E**

20

**Fig. 6**

**Fig. 7**

**Fig. 8A** — 21 / 20

M10

**Fig. 8B** — 21 / 20

P1    P2

**Fig. 8C** — 20

L1    L2

**Fig. 8D** — 20

L1    L2

**Fig. 8E** — 20

$\varepsilon_{min}$

M(L2)

M(L1)

M10

**Fig. 9**

L1   L2

**Fig. 10**

**Fig. 11**

**Fig. 12A**

**Fig. 12B**

**Fig. 13**

**Fig. 14**

**Fig. 15A**

21
20

**Fig. 15B**

M20

21
20

**Fig. 15C**

P1

20

**Fig. 15D**

L1

20

**Fig. 15E**

L1

20

**Fig. 15F**

L1

22
20

**Fig. 15G**

L1    M21

22
20

**Fig. 15H**

L1    P2

20

**Fig. 15I**

L1    L2

20

**Fig. 15J**

L1    L2

20

$\varepsilon_{min}$

M(L1)

M20

**Fig. 16**

M(L2)

M21

**Fig. 17**

L1

L2

**Fig. 18**

**Fig. 19A**
— 21
— 20

M30
**Fig. 19B**
— 21
— 20

P1
**Fig. 19C**
— 20

L1
**Fig. 19D**
— 20

L1
**Fig. 19E**
— 20

L1
**Fig. 19F**
— 22
— 20

M31
**Fig. 19G**
— 22
— 20

L1    P2
**Fig. 19H**
— 20

L1    L2
**Fig. 19I**
— 20

L1    L2
**Fig. 19J**
— 20

M(L1)    M30    M31

M(L2)

**Fig. 20**    **Fig. 21**

S1, S2

L1  L2

**Fig. 22**

**Fig. 23**

22

L1

**Fig. 24**

L2

L1

**D1**

L1

**H1**

**DF1**

**Fig. 25**

**D2**

L2

**H2**

**DF2**

**Fig. 26**

**Fig. 27A**

21
20

M40

**Fig. 27B**

21
20

P1

**Fig. 27C**

20

L1

**Fig. 27D**

20

L1

**Fig. 27E**

20

L1

**Fig. 27F**

210
20

M210

**Fig. 27G**

210
20

P210          P210

**Fig. 27H**

L1

20

P210          P210

**Fig. 27I**

L1

20

L1

**Fig. 27J**

20

**Fig. 27K**

L1

22
20

**Fig. 27L**

M41
L1

22
20

**Fig. 27M**

P2    L1

20

**Fig. 27N**

L2    L1

20

**Fig. 27O**

L2    L1

20

M(L1)    M40

**Fig. 28**

M(H)    M210

**Fig. 29**

M(L2)

M41

**Fig. 30**

L1
L2

**Fig. 31**

**Fig. 32**

**Fig. 33**

**EP 1 955 095 B1**

**Documents brevets cités dans la description**

- US 20050078377 A
- US 20050110104 A
- US 5536455 A
- US 20030215967 A